# EUROPÄISCHE PATENTSCHRIFT

(11) **EP 1 763 566 B1**
(45) Veröffentlichungstag und Bekanntmachung des Hinweises auf die Patenterteilung: **26.10.2016**
(21) Anmeldenummer: 05760036.3
(22) Anmeldetag: 06.07.2005
(51) Int. Cl.: C09K 11/06, H05B 33/14, C08G 61/02, C08G 61/12, H01L 51/00, H01L 51/50

(54) **ELEKTROLUMINESZIERENDE POLYMERE**
ELECTROLUMINESCENT POLYMERS
POLYMERES ELECTROLUMINESCENTS

(30) Priorität: 06.07.2004 DE 102004032527
(43) Veröffentlichungstag der Anmeldung: 21.03.2007
(73) Patentinhaber: Merck Patent GmbH, 64293 Darmstadt (DE)
(72) Erfinder: SCHULTE, Niels, 65779 Kelkheim (DE); HEUN, Susanne, 65812 Bad Soden (DE); BACH, Ingrid, 65719 Hofheim (DE); STÖSSEL, Philipp, 60487Frankfurt (DE); TREACHER, Kevin, Northwich, Cheshire CW8 4TG (GB)
(86) Internationale Anmeldenummer: PCT/EP2005/007290
(87) Internationale Veröffentlichungsnummer: WO 2006/003000

(56) Entgegenhaltungen:
- EP-A- 1 138 746
- EP-A- 1 245 659
- EP-A- 1 424 350
- WO-A-02/068435
- WO-A-03/102109
- WO-A-2005/030827
- WO-A-2005/033244
- WO-A-2005/042545

## Beschreibung

Seit ca. 13 Jahren läuft eine breit angelegte Forschung zur Kommerzialisierung von Anzeige- und Beleuchtungselementen auf Basis polymerer (organischer) Leuchtdioden (PLEDs). Ausgelöst wurde diese Entwicklung durch die Grundlagenentwicklungen, welche in EP 423 283 offenbart sind. Seit kurzem sind auch erste Produkte in Form kleinerer Anzeigen (in einem Rasierapparat und einem Mobiltelefon der Fa. PHILIPS N.V.) auf dem Markt erhältlich.

Eine Entwicklung, die sich seit einigen Jahren vor allem auf dem Gebiet der "Small molecule"-Displays abzeichnet, ist der Einsatz von Materialien, die aus dem Triplett-Zustand Licht emittieren können und somit Phosphoreszenz statt Fluoreszenz zeigen (M. A. Baldo et al., Appl. Phys. Lett. 1999, 75, 4-6), wodurch eine bis zu vierfache Energie- und Leistungseffizienz möglich ist. Als wesentliche Bedingungen für die praktische Anwendbarkeit sind hier insbesondere die effiziente Lichtemission, eine lange Lebensdauer und die gute synthetische Zugänglichkeit der Verbindungen zu nennen.

In letzter Zeit gibt es zunehmend Bemühungen, sich die Vorteile aufdampfbarer Triplett-Emitter auch für Polymeranwendungen zu Nutze zu machen. So werden so genannte Hybrid-Device-Strukturen erwogen, die die Vorteile der "Small-molecule"-OLEDs mit denen der Polymer-OLEDs (= PLEDs) verbinden und durch Mischen des Triplett-Emitters in das Polymer entstehen. Vorteilhafter ist es jedoch, den Triplett-Emitter in ein Polymer einzubauen, da dadurch die Gefahr der Phasenseparation bei Deviceherstellung und -betrieb vermieden wird. Beide Methoden haben den Vorteil, dass die Verbindungen aus Lösung verarbeitet werden können und dass kein teurer und aufwändiger Aufdampfprozess wie für Devices auf Basis niedermolekularer Verbindungen erforderlich ist. Das Aufbringen aus Lösung (z. B. durch hochauflösende Druckverfahren) wird langfristig deutliche Vorteile gegenüber dem heute gängigen Vakuum-Verdampfungsprozess aufweisen, v. a. hinsichtlich Skalierbarkeit, Strukturierbarkeit, Beschichtungseffizienz und Ökonomie.

Trotz der in letzter Zeit erzielten Fortschritte gibt es immer noch erhebliches Verbessungspotenzial auf dem Gebiet der polymeren Triplett-Emitter. U. a. auf folgenden Feldern ist weiterhin ein deutlicher Verbesserungsbedarf zu sehen:
(1) Die Effizienz der Elektrolumineszenzelemente muss weiter verbessert werden. Dass prinzipiell eine höhere Effizienz möglich ist, zeigen die Ergebnisse von Elektrolumineszenzelementen auf Basis kleiner Moleküle, die im Vakuum aufgebracht werden.
(2) Die Betriebsspannung der Elektrolumineszenzelemente ist zu hoch für hochwertige elektronische Anwendungen.
(3) Die Lebensdauer der Elektrolumineszenzelemente ist bislang noch nicht ausreichend für hochwertige elektronische Anwendungen.
(4) Die synthetische Zugänglichkeit von phosphoreszierenden Polymeren mit kovalent gebundenen Triplett-Emittern ist bislang nur nach sehr aufwändigen Methoden möglich. So ist es bisher nötig, mono- oder bifunktionalisierte Triplett-Emitter zu synthetisieren, die beispielsweise bei den am weitesten verbreiteten Materialien, basierend auf tris-ortho-metallierten Iridiumkomplexen, nur in mehrstufigen Syntheseverfahren und nicht immer in befriedigenden Ausbeuten zugänglich sind. Somit ist eine einfache und ressourcenschonende Nutzung dieser seltenen Metalle bislang nicht möglich.
Es ist also offensichtlich, dass auf dem Gebiet polymergebundener Triplett-Emitter weiterhin ein großer Verbesserungsbedarf besteht.

In WO 02/068435 werden mono-, di- und trihalogenierte Iridiumkomplexe beschrieben, die auch als Monomere zur Synthese von Polymeren eingesetzt werden können. Jedoch ist nicht angegeben, welche dieser Komplexe sich dafür bevorzugt eignen, so dass angenommen werden muss, dass sich hier die monohalogenierten Komplexe zum Einbau in die Seitenkette und die dihalogenierten Komplexe zum Einbau in die Hauptkette eignen, während die trihalogenierten Komplexe durch Vernetzung zu unlöslichen Polymeren führen sollten.

In WO 02/077060 und in WO 03/020790 werden Copolymere beschrieben, die Spirobifluoren-Einheiten enthalten und die zusätzlich auch Metallkomplexe enthalten können, die aus dem Triplett-Zustand Licht emittieren können und somit Phosphoreszenz statt Fluoreszenz zeigen. Als bevorzugte Ausführungsform sind Metallkomplexe beschrieben und abgebildet, die zwei Verknüpfungen zum Polymer aufweisen und die somit in die Polymerhauptkette eingebaut sind. Die hier gezeigten Strukturen haben jedoch den Nachteil, dass dafür unsymmetrische Metallkomplexe benötigt werden, die synthetisch nicht einfach zugänglich sind. Jedoch kann aus der Beschreibung nicht gefolgert werden, dass andere Metallkomplexe, die nicht linear in die Polymerhauptkette eingebaut werden, besondere Vorteile für die Elektrolumineszenz bieten.

In der EP 1424350 A1 und der WO 03/102109 A1 werden phosphoreszierende Polymere offenbart, die neben Ladungstransport-Einheiten phosphoreszierende Einheiten aufweisen. Die phosphoreszierenden Einheiten können dabei in der Haupt- oder in der Seitenkette angeordnet sein.

Weiterhin bekannt sind Dendrimere, die aus dem Triplettzustand Licht emittieren, wie beispielsweise in WO 02/066552, WO 03/079736 und WO 04/020448 beschrieben, die ebenso wie Polymere aus Lösung verarbeitet werden können. Diese Dendrimere haben jedoch den entscheidenden Nachteil, dass ihre synthetische Zugänglichkeit extrem aufwändig ist, da die einzelnen Generationen des Dendrimers in separaten Reaktionsschritten aufgebaut und jeweils isoliert und gereinigt werden müssen. Dadurch sind die Ausbeuten gering, und man erleidet große Verluste an den verwendeten seltenen Metallen. Die Verwendung dieser Dendrimere bietet somit keine echte Alternative zu phosphoreszierenden Polymeren, die in einem einzigen Syntheseschritt aufgebaut werden können.

Daher stellte sich die Aufgabe, wie phosphoreszierende Polymere, die gute Eigenschaften in der Elektrolumineszenz zeigen, leicht und aus synthetisch gut zugänglichen Verbindungen aufgebaut werden können, wobei Kompatibilität mit üblichen Polymerisationstechniken im Sinne eines Eintopfverfahrens angestrebt wurde.

Überraschend wurde gefunden, dass - bisher unbekannte - phosphoreszierende Copolymere, die Verzweigungen an den Triplett-Emittern aufweisen, deutliche Verbesserungen im Vergleich zu Polymeren und Mischungen gemäß dem Stand der Technik aufweisen, insbesondere hohe Emissionseffizienz, niedrige Betriebsspannung und lange Lebensdauer bei gleichzeitig einfacher synthetischer Zugänglichkeit und guter Löslichkeit. Dies ist insbesondere überraschend, da erwartet wurde, dass die Copolymere aufgrund der Verzweigungen (und folglich Vernetzung) unlöslich sind und sich nicht aus Lösung verarbeiten lassen. Weiterhin überraschend ist, dass diese Polymere überhaupt Phosphoreszenz bzw. Elektrophosphoreszenz zeigen, da verwandte Polymere Fluoreszenz bzw. Elektrofluoreszenz zeigen. Diese phosphoreszierenden Copolymere sind daher Gegenstand der vorliegenden Anmeldung.

Verwandte fluoreszierende Copolymere, die Verzweigungen in der Polymerkette aufweisen, wurden bereits in der Literatur beschrieben (EP 1138746). Diese Verzweigungen können dabei unter anderem auch durch Metallkomplexe erzeugt werden. Diese Verbindungen sind jedoch in dieser Patentanmeldung nur unzureichend geschildert, so dass aus der Beschreibung nicht hervorgeht, wie sie nutzbringend aufgebaut und eingesetzt werden können. Da es sich um *fluoreszierende* und nicht um *phosphoreszierende* Polymere handelt, scheint es, dass die Metallkomplexe nur als strukturelle Verzweigungspunkte eingesetzt wurden, nicht jedoch eine elektronische Bedeutung im Polymer erlangen. Auch aus den aufgeführten Beispielen geht nicht hervor, weshalb insbesondere diese Polymere besonders gute Eigenschaften haben sollen. So wird zwar die in diesem Fall sehr aufwändige Synthese der fluoreszierenden Polymere beschrieben, die Tris(phenylpyridyl)iridium(III)-Komplexe enthalten, die in die Hauptkette, als Endgruppe und als Verzweigung eingebaut sind, jedoch sind keine physikalischen Eigenschaften der Polymere aufgeführt, so dass davon ausgegangen werden muss, dass diese Polymere zwar möglicherweise verbesserte rheologische Eigenschaften zeigen, jedoch in der Fluoreszenz bzw. in der Elektrofluoreszenz keine herausragenden Ergebnisse liefern. So scheint die Kombination von 9,9-Dioctylfluoren als Backbone mit unsubstituiertem Tris(phenylpyridin)iridium(III) nicht zur Synthese phosphoreszierender Polymere geeignet zu sein.
In EP 1245659 werden Polymere beschrieben, die in der Haupt- oder in der Seitenkette Metallkomplexe enthalten, die aus dem Triplettzustand Licht emittieren können und somit Phosphoreszenz statt Fluoreszenz zeigen. Nach dem allgemeinen Verständnis kann hier davon ausgegangen werden, dass es sich in erster Linie um lineare Polymere handelt. Hier geht aus der Beschreibung nicht hervor, dass es bevorzugt sein könnte, wenn die Metallkomplexe Verzweigungen aufweisen. Im Gegenteil werden in den Beispielen die identischen Polymere angeführt wie im oben zitierten Patent EP 1138746, von denen bereits dort beschrieben war, dass diese Fluoreszenz und keine Phosphoreszenz zeigen. Dadurch wird eine irreführende Lehre erteilt, und es lässt sich folgern, dass die Verwendung von Metallkomplexen als Verzweigungspunkt ungeeignet ist, um phosphoreszierende Polymere zu konstruieren.

Gegenstand der Erfindung sind phosphoreszierende Copolymere, enthaltend 0.05 bis 10 mol% mindestens eines Triplett-Emitters, dadurch gekennzeichnet, dass der Triplett-Emitter mindestens drei Verknüpfungen zu dem Polymer aufweist, mit der Maßgabe, dass das Polymer kein 9,9-Dioctylfluoren enthält, wenn der Triplett-Emitter ein unsubstituiertes Tris(phenylpyridin)iridium(III) ist.

Unter Phosphoreszenz im Sinne dieser Erfindung wird eine durch äußere Energie, z. B. Licht oder elektrischen Strom, angeregte Lumineszenz verstanden, bei der die Emission durch einen Übergang aus einem Triplett-Zustand oder einem Mischzustand aus einem angeregten Singulett- und einem Triplett-Zustand in den Singulett-Grundzustand erzeugt wird. Dagegen wird unter Fluoreszenz im Sinne dieser Erfindung eine durch äußere Energie angeregte Lumineszenz verstanden, bei der die Emission durch einen Übergang aus einem angeregten Singulett-Zustand in den Singulett-Grundzustand erzeugt wird. Diese beiden Prozesse lassen sich experimentell durch die Lebensdauern der angeregten Zustände unterscheiden, wobei die Lebensdauer des angeregten Singulett-Zustands in der Größenordnung von 10⁻¹⁰ bis 10⁻⁷ s liegt und die des Triplett-Zustands in der Größenordnung von > 10⁻⁷ s liegt, was durch zeitaufgelöste Lumineszenz-Spektroskopie zu ermitteln ist. Unter einem Triplett-Emitter im Sinne dieser Erfindung soll eine Verbindung, insbesondere ein Metallkomplex, verstanden werden, die bei Raumtemperatur in der Elektrolumineszenz aus dem Triplettzustand Licht emittiert, also Elektrophosphoreszenz statt Elektrofluoreszenz zeigt. Hierfür eignen sich insbesondere Metallkomplexe, die mindestens ein Metall mit der Ordnungszahl größer 38 enthalten, wobei nicht alle Polymere, die solche Metallkomplexe enthalten, deswegen zwangsläufig befähigt sind, Phosphoreszenz zu zeigen.

Die mindestens drei Verknüpfungen des Triplett-Emitters zum Polymer können dadurch erhalten werden, dass ein mindestens trifunktionalisierter Triplett-Emitter eingesetzt wird, was zu Verzweigungen des Polymers führt.

Die erfindungsgemäßen phosphoreszierenden Copolymere unterscheiden sich von den oben erwähnten Dendrimeren dadurch, dass die Verzweigungen statistisch im Polymer angeordnet sind, während sie im Dendrimer in regelmäßiger Anordnung vorliegen. Dadurch vereinfacht sich die Synthese im Vergleich zu Dendrimeren erheblich, da eine Eintopfsynthese möglich ist. Weiterhin weist im Dendrimer jede Wiederholeinheit eine Verzweigung auf, während im erfindungsgemäßen Polymer nur ein Teil der Wiederholeinheiten, bevorzugt nur der Triplett-Emitter, Verzweigungen aufweist. Weiterhin unterscheiden sie sich von den oben aufgeführten verzweigten Polymeren (EP 1138746), deren Verzweigungspunkte durch Metallkomplexe beschrieben werden, dadurch, dass sie phosphoreszieren und nicht fluoreszieren. Dadurch zeigen die erfindungsgemäßen Copolymere in der Elektrolumineszenz deutlich höhere Effizienzen als die entsprechenden fluoreszierenden Polymere, die die Metallkomplexe lediglich als Verzweigungspunkte ohne elektronischen Einfluss enthalten.

Das erfindungsgemäße phosphoreszierende Copolymer kann konjugiert, teilkonjugiert oder nicht-konjugiert sein. Bevorzugt ist das erfindungsgemäße Copolymer konjugiert oder teilkonjugiert.

Konjugierte Polymere im Sinne dieser Erfindung sind Polymere, die in der Hauptkette hauptsächlich sp²-hybridisierte (bzw. auch sp-hybridisierte) Kohlenstoffatome enthalten, die auch durch entsprechende Heteroatome ersetzt sein können. Dies bedeutet im einfachsten Fall abwechselndes Vorliegen von Doppel- und Einfachbindungen in der Hauptkette. Hauptsächlich meint, dass natürlich (ohne weiteres Zutun) auftretende Defekte, die zu Konjugationsunterbrechungen führen, den Begriff "konjugiertes Polymer" nicht entwerten. Des Weiteren wird in diesem Anmeldetext ebenfalls als konjugiert bezeichnet, wenn sich in der Hauptkette Arylamineinheiten, Arylphosphineinheiten und/oder bestimmte Heterocyclen (d. h. Konjugation über N-, O-, S- oder P-Atome) und/oder metallorganische Komplexe, wie beispielsweise Iridium-Komplexe (Konjugation über das Metallatom), befinden. Teilkonjugierte Polymere im Sinne dieser Erfindung sind Polymere, die entweder in der Hauptkette längere konjugierte Abschnitte enthalten, die durch nicht-konjugierte Abschnitte unterbrochen werden, oder die in den Seitenketten eines in der Hauptkette nicht-konjugierten Polymers längere konjugierte Abschnitte enthalten. Hingegen würden Einheiten, wie beispielsweise einfache Alkylenketten, (Thio)Etherbrücken, Ketogruppen, Ester-, Amid- oder Imidverknüpfungen eindeutig als nicht-konjugierte Segmente definiert.

Die erfindungsgemäßen phosphoreszierenden Copolymere können außer dem Triplett-Emitter verschiedene weitere Strukturelemente enthalten. Diese können unter anderem Strukturelemente sein, die das Polymergrundgerüst bilden, oder solche, die die Ladungsinjektions- bzw. Ladungstransporteigenschaften beeinflussen. Solche Einheiten sind beispielsweise in WO 03/020790 und WO 05/014689 ausführlich beschrieben. Auch Strukturelemente, die für effiziente Anregungsübertragung sorgen, wie weitere einpolymerisierte Farbstoffe, sind möglich.

Bevorzugte Strukturelemente, die als Polymergrundgerüst (Backbone) verwendet werden können, sind beispielsweise Fluorenderivate, Spirobifluorenderivate, 9,10-Dihydrophenanthrenderivate, 4,5-Dihydropyrenderivate, 4,5,9,10-Tetrahydropyrenderivate, Phenanthrenderivate und cis- und trans-Indenofluorenderivate, die jeweils substituiert oder unsubstituiert sein können. Besonders bevorzugte Strukturelemente, die als Polymergrundgerüst (Backbone) verwendet werden können, sind Spirobifluorenderivate, Phenanthrenderivate und cis- und trans-Indenofluorenderivate, ganz besonders bevorzugt sind Spirobifluorenderivate und Phenanthrenderivate, wobei weiterhin sehr gute Ergebnisse und sehr effiziente Phosphoreszenz erzielt werden, wenn diese Einheiten in Kombination mit anderen Grundgerüsteinheiten verwendet werden. Wenn als Grundgerüst Spirobifluorenderivate verwendet werden, so sind diese bevorzugt mit Alkylketten substituiert.

Bevorzugte Strukturelemente, die Lochtransporteigenschaften aufweisen, sind beispielsweise Triarylaminderivate, Benzidinderivate, Tetraarylen-para-phenylendiaminderivate, Triarylphosphinderivate, Phenothiazinderivate, Phenoxazinderivate, Dihydrophenazinderivate, Thianthrenderivate, Dibenzo-p-dioxinderivate, Phenoxathiinderivate, Carbazolderivate, Azulenderivate, Thiophenderivate, Pyrrolderivate, Furanderivate und weitere O-, S- oder N-haltige Heterocyclen mit hoch liegendem HOMO (HOMO = höchstliegendes besetztes Molekülorbital); bevorzugt führen diese Arylamine und Heterocyclen zu einem HOMO im Polymer von weniger als 5.8 eV (gegen Vakuumlevel), besonders bevorzugt von weniger als 5.5 eV.

Bevorzugte Strukturelemente, die Elektronentransporteigenschaften aufweisen, sind beispielsweise Pyridinderivate, Pyrimidinderivate, Pyridazinderivate, Pyrazinderivate, Anthracenderivate, Pyrenderivate, Triarylborane, Oxadiazolderivate, Chinolinderivate, Chinoxalinderivate, Phenazinderivate und weitere O-, S- oder N-haltige Heterocyclen mit niedrig liegendem LUMO (LUMO = niedrigstes unbesetztes Molekülorbital); bevorzugt führen diese Einheiten im Polymer zu einem LUMO von mehr als 2.7 eV (gegen Vakuumlevel), besonders bevorzugt von mehr als 3.0 eV.

Weiterhin bevorzugt können die Copolymere auch Strukturelemente enthalten, die für effiziente Anregungsübertragung sorgen und den Übergang vom Singulett- zum Triplett-Zustand verbessern. Hierfür eignen sich beispielsweise Carbazol-Einheiten (z. B. gemäß WO 04/070772 und WO 04/113468), Keto-, Phosphinoxid- oder Sulfoxid-haltige Strukturelemente (z. B. gemäß den nicht offen gelegten Anmeldungen DE 10349033.7 und DE 102004003008.1) oder Arylsilan-Einheiten (z. B. gemäß der nicht offen gelegeten Anmeldung DE 102004023278.4). Einheiten, die den Übergang vom Singulett- zum Triplett-Zustand verbessern, können auch solche sein, die selber auch aus dem Singulett- oder aus dem Triplett-Zustand emittieren können; diese können linear oder ebenfalls verzweigt sein. Bevorzugt ist die Verwendung von Keto- oder Phosphinoxideinheiten, insbesondere solchen, die durch aromatische Gruppen substituiert sind. Besonders bevorzugt ist die Verwendung von aromatischen Ketoeinheiten, beispielsweise Benzophenon.

Ein weiterer Gegenstand der Erfindung sind weiß emittierende Copolymere, in denen die weiße Emission eine Kombination der Emission blau, grün und rot emittierender Einheiten ist, dadurch gekennzeichnet, dass mindestens eine der emittierenden Einheiten ein Triplett-Emitter ist, mindestens drei Verknüpfungen zu dem Polymer aufweist.

Die erfindungsgemäßen Copolymere können statistische, alternierende oder auch blockartige Strukturen aufweisen oder auch mehrere dieser Strukturen abwechselnd besitzen. Dadurch können elektronische Eigenschaften, wie z. B. Ladungstransport, eingestellt werden, aber auch die Morphologie des Polymers kann durch unterschiedliche räumliche Anordnung der Verzweigungspunkte beeinflusst werden. Die Synthese von Copolymeren mit blockartigen Strukturen ist beispielsweise in WO 05/014688 beschrieben.

Das Molekulargewicht M_{w} der Polymere liegt zwischen 10³ und 10⁷ g/mol, bevorzugt zwischen 10⁴ und 10⁶ g/mol, besonders bevorzugt zwischen 5·10⁴ und 8·10⁵ g/mol.

Die erfindungsgemäßen Copolymere werden durch Polymerisation entsprechender Monomere hergestellt, wobei mindestens ein Monomer den trifunktionalisierten bzw. höher funktionalisierten Triplett-Emitter bzw. einen entsprechenden Liganden zur Koordination des Metalls beinhaltet. Insbesondere für die Synthese konjugierter und teilkonjugierter Polymere haben sich hier einige Typen bewährt, die alle zu C-C-Verknüpfungen (SUZUKI-Kupplung, YAMAMOTO-Kupplung, STILLE-Kupplung) führen. Wie die Polymerisation nach diesen Methoden durchgeführt werden kann und wie die Polymere vom Reaktionsmedium abgetrennt und gereinigt werden können, ist beispielsweise in der WO 03/048225 oder in WO 04/022626 beschrieben. Nach diesen Methoden kann auch die Synthese nicht-konjugierter Polymere durchgeführt werden, indem entsprechende Monomere verwendet werden, die nicht durchgängig konjugiert sind. Für teilkonjugierte oder nicht-konjugierte Polymere kommen auch andere Synthesemethoden in Frage, wie sie allgemein aus der Polymerchemie geläufig sind, wie beispielsweise allgemein Polykondensationen oder kationische, anionische oder radikalische Polymerisationen. Es kann auch sinnvoll sein, in der Polymerisationsreaktion monofunktionelle Verbindungen einzusetzen. Dadurch kann einerseits der Molekulargewichtsbereich des Polymers eingestellt werden. Andererseits können über monofunktionelle Verbindungen die ebenfalls verwendeten trifunktionellen bzw. höher funktionellen Verbindungen (trifunktionelle bzw. höher funktionelle Triplett-Emitter) kompensiert werden.

Das Auftreten von Verzweigungen in den erfindungsgemäßen phosphoreszierenden Copolymeren kann beispielsweise über die Molekulargewichtsverteilung (bestimmt über GPC) nachgewiesen werden. Während bei der Polykondensation eines linearen Polymers gemäß SUZUKI unter den hier gewählten Reaktionsbedingungen im Allgemeinen Polydispersitäten im Bereich von 2.5 bis 4 gefunden werden, liegen die Polydispersitäten der erfindungsgemäßen phosphoreszierenden Copolymere im Bereich von 5 bis 6 und damit deutlich höher als für die linearen Polymere, wie man es für verzweigte Polymere auch erwarten würde.

Bei der Synthese der phosphoreszierenden Polymere kann der entsprechend trifunktionalisierte bzw. höher funktionalisierte Triplett-Emitter direkt als Monomer eingesetzt werden. Es kann aber auch ein entsprechend substituierter Ligand in der Polymerisationsreaktion eingesetzt und die Komplexierung des Metalls am fertig aufgebauten Polymer bzw. Oligomer durchgeführt werden. Da polymeranaloge Reaktionen im Allgemeinen schwierig durchzuführen sind und insbesondere die Reinigung der Polymere nach der Reaktion schwierig oder unmöglich ist, ist es bevorzugt, den trifunktionalisierten bzw. höher funktionalisierten Triplett-Emitter als Monomer einzusetzen.

Es hat sich gezeigt, dass ein Anteil von 0.05 - 10 mol%, besonders bevorzugt 0.1-5 mol%, insbesondere 0.5 - 3 mol% des Triplett-Emitters gute Ergebnisse zeigt, wobei sich die Angaben auf die gesamt vorhandenen Wiederholeinheiten im Polymer beziehen. Dies ist ein überraschendes Ergebnis, da gemäß dem Stand der Technik der Anteil des Triplett-Emitters in Copolymeren und Blends deutlich höher ist, um effiziente Phosphoreszenz zu erreichen. Mit den erfindungsgemäßen Polymeren erzielt man sehr gute Ergebnisse mit diesem geringen Anteil des Triplett-Emitters, und die Prozessierbarkeit der Polymere ist gut, was bei einem höheren Anteil des Triplett-Emitters nicht immer gegeben ist.

Weiterhin hat sich gezeigt, dass es bevorzugt ist, wenn mindestens 20 % der Triplett-Emitter, bevorzugt mindestens 30 % der Triplett-Emitter, besonders bevorzugt mindestens 50 % der Triplett-Emitter, insbesondere überwiegend alle eingesetzten Triplett-Emitter mindestens drei Verknüpfungen zur Polymerkette aufweisen, besonders bevorzugt genau drei Verknüpfungen zur Polymerkette, und damit Verzweigungspunkte darstellen. Außerdem ist es bevorzugt, wenn nur die Triplett-Emitter und keine weiteren Einheiten im Polymer Verzweigungen aufweisen.

Die im phosphoreszierenden Copolymer gebundenen Triplett-Emitter sind bevorzugt metallorganische Komplexe. Unter einer metallorganischen Verbindung soll eine Verbindung verstanden werden, die mindestens eine direkte Metall-Kohlenstoff-Bindung aufweist. Weiterhin bevorzugt handelt es sich um elektrisch neutrale Triplett-Emitter und um elektrisch neutrale Copolymere.

Bevorzugt enthalten die Triplett-Emitter nur chelatisierende Liganden, d. h. Liganden, die über mindestens zwei Bindungsstellen an das Metall koordinieren; besonders bevorzugt ist die Verwendung von zwei oder drei zweizähnigen Liganden, die gleich oder verschieden sein können. Die Bevorzugung chelatisierender Liganden lässt sich durch die höhere Stabilität von Chelatkomplexen begründen. Dabei weist der Triplett-Emitter im Polymer bevorzugt eine Struktur gemäß Formel (1) auf, 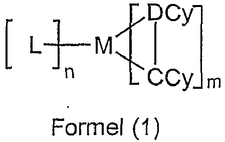 wobei für die verwendeten Symbole und Indizes gilt:
- M: ist bei jedem Auftreten gleich oder verschieden ein Hauptgruppenmetall, Übergangsmetall oder Lanthanoid mit der Ordnungszahl > 38;
- DCy: ist bei jedem Auftreten gleich oder verschieden eine cyclische Gruppe, die mindestens ein Donoratom, also ein Atom mit einem freien Elektronenpaar, bevorzugt Stickstoff oder Phosphor, enthält, über welches die cyclische Gruppe an das Metall gebunden ist, und die einen oder mehrere Substituenten R¹ tragen kann; die Gruppen DCy und CCy sind über eine kovalente Bindung miteinander verbunden und können über die Reste R¹ bzw. R² noch weitere Verknüpfungen miteinander aufweisen;
- CCy: ist bei jedem Auftreten gleich oder verschieden eine cyclische Gruppe, die ein Kohlenstoffatom enthält, über welches die cyclische Gruppe an das Metall gebunden ist, und die einen oder mehrere Substituenten R¹ tragen kann;
- L: ist bei jedem Auftreten gleich oder verschieden ein zweizähnig chelatisierender Ligand, bevorzugt ein monoanionischer, zweizähnig chelatisierender Ligand;
- R¹: ist bei jedem Auftreten gleich oder verschieden H, F, Cl, Br, I, NO₂, CN, eine geradkettige, verzweigte oder cyclische Alkyl- oder Alkoxygruppe mit 1 bis 40 C-Atomen, wobei eine oder mehrere nicht benachbarte CH₂-Gruppen durch C=O, C=S, C=Se, C=NR², -R²C=CR²-, -C≡C-, -O-, -S-, -NR²-, Si(R²)₂ oder -CONR²- ersetzt sein können und wobei ein oder mehrere H-Atome durch F, Cl, Br, I, CN, NO₂ ersetzt sein können, oder ein aromatisches oder heteroaromatisches Ringsystem mit 5 bis 40 aromatischen Ringatomen, das durch einen oder mehrere nicht-aromatische Reste R¹ substituiert sein kann; dabei können mehrere Substituenten R¹, sowohl am selben Ring als auch an den beiden unterschiedlichen Ringen zusammen wiederum ein weiteres mono- oder polycyclisches, aliphatisches oder aromatisches Ringsystem aufspannen;
- R²: ist gleich oder verschieden bei jedem Auftreten H oder ein aliphatischer oder aromatischer Kohlenwasserstoffrest mit 1 bis 20 C-Atomen;
- m: ist bei jedem Auftreten 1, 2 oder 3, bevorzugt 2 oder 3, besonders bevorzugt 3;
- n: ist bei jedem Auftreten 0, 1 oder 2, bevorzugt 0 oder 1, besonders bevorzugt 0;
dabei bestehen mindestens drei Verknüpfungen der Einheit gemäß Formel (1) mit dem Polymer.

Die Anknüpfung an das Polymer kann über einen oder über mehrere Liganden erfolgen, bevorzugt über mindestens zwei Liganden, besonders bevorzugt über drei Liganden oder über vier Liganden.

Bevorzugt sind ebenfalls mehrkernige Triplett-Emitter und Metall-Cluster, deren gemeinsames Merkmal mehr als ein metallisches Zentrum ist.

Die Einheiten gemäß Formel (1) können symmetrisch oder unsymmetrisch aufgebaut sein.
In einer bevorzugten Ausführungsform der Erfindung sind die Einheiten gemäß Formel (1) symmetrisch aufgebaut. Diese Bevorzugung ist aus der leichteren synthetischen Zugänglichkeit der Verbindungen zu begründen. So kann es sich bei Einheiten gemäß Formel (1) bevorzugt um homoleptische Metallkomplexe handeln, also Metallkomplexe, die nur eine Art Liganden aufweisen.
In einer weiteren bevorzugten Ausführungsform der Erfindung sind die Einheiten gemäß Formel (1) unsymmetrisch aufgebaut. Dies kann bei den Emissionseigenschaften Vorteile bieten, wenn die Emission nur aus einem der Liganden kommt. So kann es sich bei Einheiten gemäß Formel (1) bevorzugt um heteroleptische Komplexe handeln, also Metallkomplexe, die mehr als einen unterschiedlichen Liganden aufweisen.

Bevorzugte Metalle M sind ausgewählt aus der Gruppe der Übergangsmetalle mit einer Ordnungszahl > 38; besonders bevorzugte Metalle M sind ausgewählt aus der Gruppe der Übergangsmetalle mit einer Ordnungszahl > 50; ganz besonders bevorzugte Metalle sind ausgewählt aus den Elementen Wolfram, Rhenium, Ruthenium, Osmium, Rhodium, Iridium, Palladium, Platin und Gold, insbesondere Iridium und Platin.

Der Triplett-Emitter wird kovalent in die Polymerkette eingebaut. Um den Einbau des Komplexes in das Polymer zu ermöglichen, müssen am Komplex funktionelle polymerisierbare Gruppen vorhanden sein. Hier kann es bevorzugt sein, erst den vollständigen Komplex aufzubauen und an diesem die Funktionalisierung, beispielsweise durch Halogenierung, durchzuführen. Ebenso kann es bevorzugt sein, bereits am Liganden die Funktionalisierung durchzuführen und mit dem funktionalisierten Liganden die Komplexierung durchzuführen. Beispiele für entsprechende bromierte Komplexe, die als Monomere in Polykondensationsreaktionen (beispielsweise gemäß SUZUKI oder gemäß YAMAMOTO) eingesetzt werden können, und deren Synthesen werden in WO 02/068435 beschrieben.

Es kann auch bevorzugt sein, dem phosphoreszierenden Polymer noch weitere konjugierte, teilkonjugierte oder nicht-konjugierte Polymere, Oligomere, Dendrimere oder niedermolekulare Verbindungen beizumischen. Die Zugabe weiterer Komponenten kann sich für manche Anwendungen als sinnvoll erweisen: So kann beispielsweise durch Zugabe einer elektronisch aktiven Substanz die Loch- bzw. Elektroneninjektion oder der Loch- bzw. Elektronentransport im entsprechenden Blend verbessert werden. Die Zusatzkomponente kann auch den Singulett-Triplett-Transfer verbessern oder selber Licht emittieren. Auch die Zugabe elektronisch inerter Verbindungen kann hilfreich sein, um beispielsweise die Viskosität einer Lösung oder die Morphologie des gebildeten Films zu kontrollieren. Die so erhaltenen Blends sind ebenfalls Gegenstand der vorliegenden Erfindung.

Gegenstand der Erfindung sind weiterhin Lösungen und Formulierungen aus einem oder mehreren erfindungsgemäßen phosphoreszierenden Copolymeren oder Blends in einem oder mehreren Lösungsmitteln. Wie Polymerlösungen hergestellt werden können, ist beispielsweise in WO 02/072714, in WO 03/019694 und in der darin zitierten Literatur beschrieben. Diese Lösungen können verwendet werden, um dünne Polymerschichten herzustellen, zum Beispiel durch Flächenbeschichtungsverfahren (z. B. Spin-coating) oder Druckverfahren (z. B. InkJet Printing).

Die erfindungsgemäßen phosphoreszierenden Copolymere können in PLEDs verwendet werden, insbesondere als Elektrolumineszenzmaterialien (= emittierende Materialien). Für den Bau von PLEDs wird in der Regel ein allgemeines Verfahren verwendet, das entsprechend für den Einzelfall anzupassen ist. Ein solches Verfahren wurde beispielsweise in WO 04/037887 ausführlich beschrieben. Diese PLEDs enthalten in der Regel noch mindestens eine Lochinjektionsschicht, beispielsweise aus PEDOT (dotiertes Poly-ethylendixoythiophen); auch die Verwendung einer Zwischenschicht zwischen der emittierenden Schicht und der Lochinjektionsschicht kann sich als sinnvoll erweisen, beispielsweise zur Steigerung der Lebensdauer.

Gegenstand der Erfindung ist daher auch die Verwendung eines erfindungsgemäßen phosphoreszierenden Copolymers in einer PLED.

Gegenstand der Erfindung ist ebenfalls eine PLED mit einer oder mehreren Schichten, wobei mindestens eine dieser Schichten mindestens ein erfindungsgemäßes phosphoreszierendes Copolymer enthält.

Die erfindungsgemäßen phosphoreszierenden Copolymere weisen gegenüber dem Stand der Technik die folgenden überraschenden Vorteile auf:
- Die Effizienz der Lichtemission des Triplett-Emitters ist in erfindungsgemäßen Copolymeren vergleichbar oder besser im Vergleich zu Copolymeren gemäß dem Stand der Technik. Dies ist insbesondere der Fall gegenüber den in EP 1138746 genannten verzweigten Copolymeren, die Fluoreszenz zeigen, wobei diese nicht aus dem Metallkomplex, sondern aus dem PolymerGrundgerüst stammt und deren Effizienz dadurch deutlich geringer ist als in erfindungsgemäßen Copolymeren. Auch im Vergleich zu Blends aus vergleichbaren Polymeren, die keine Metallkomplexe enthalten, mit niedermolekularen Metallkomplexen ist die Effizienz höher.
- Die Lebensdauer ist höher im Vergleich zu Copolymeren gemäß dem Stand der Technik.
- Im Vergleich zu phosphoreszierenden Mischungen gemäß dem Stand der Technik besteht bei den erfindungsgemäßen phosphoreszierenden Copolymeren nicht das Problem der Entmischung der Komponenten, was zu einer gleichmäßigeren Lichtemission aus dem entsprechenden Pixel führt.
- Die erfindungsgemäßen phosphoreszierenden Polymere sind überraschend gut löslich und lassen sich daher auch sehr gut aus Lösung verarbeiten.
- Die erfindungsgemäßen phosphoreszierenden Polymere sind synthetisch einfach und in hoher Ausbeute erhältlich, was bei Polymeren gemäß dem Stand der Technik nicht der Fall ist. Dadurch wird die ressourcenschonende Anwendung der seltenen Metalle in den Triplett-Emittern möglich.
- Die Polymere enthalten weniger Triplett-Emitter als Polymere gemäß dem Stand der Technik. Dies trägt weiter zur ressourcenschonenden Anwendung der seltenen Metalle bei.

Im vorliegenden Anmeldetext und in den folgenden Beispielen wird auf die Verwendung erfindungsgemäßer phosphoreszierender Copolymere in Bezug auf PLEDs und die entsprechenden Displays abgezielt. Trotz dieser Beschränkung der Beschreibung ist es für den Fachmann ohne weiteres erfinderisches Zutun möglich, die erfindungsgemäßen Polymere auch für weitere Verwendungen in anderen elektronischen Devices (Vorrichtungen) zu benutzen, z. B. für organische Solarzellen (O-SCs), nicht-lineare Optik, organische optische Detektoren, organische Feld-Quench-Devices (O-FQDs) oder auch organische Laserdioden (O-Laser), um nur einige Anwendungen zu nennen. Auch diese sind Gegenstand der vorliegenden Erfindung.

Die Erfindung wird durch die nachfolgenden Beispiele näher erläutert, ohne sie dadurch einschränken zu wollen.

### Beispiele

### Beispiel 1: Synthese der Iridium-Verbindungen

### a) Synthese von Tris(3-bromphenyl-isochinolin)-iridium (Ir1)

Die Synthese des Monomers **Ir1** wurde durch Bromierung von Tris(phenyl-isochinolin)-iridium(III) gemäß WO 02/068435 durchgeführt.

### b) Synthese von Bis(3-bromphenyl-isochinolin)(phenylisochinolin)-iridium (Ir2) und von Bis(3-bromphenyl-isochinolin)(benzothienylpyridyl)-iridium (Ir3)

Die Synthesen der Monomere **Ir2** und **Ir3** wurden gemäß der nicht offen gelegten Anmeldung DE 10350606.3 durchgeführt.

### c) Synthese einer löslichen Iridiumverbindung (Ir4)

Die lösliche Variante eines Iridiumkomplexes (**Ir4**) wurde aus dem Monomer **Ir1** durch Suzuki-Kupplung gemäß WO 04/026886 erhalten.

Die Struktur der Iridium-Verbindungen sind hier der Übersichtlichkeit halber nochmals abgebildet:

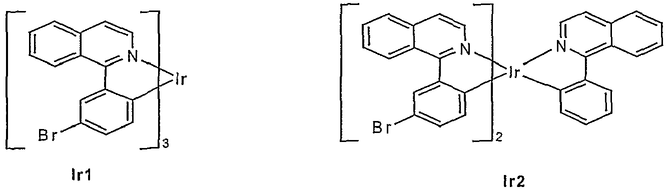

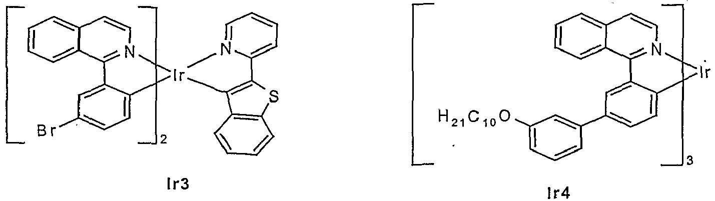

### Beispiel 2: Synthese weiterer Comonomere

Die Synthese der weiteren verwendeten Comonomere und monofunktionellen Verbindungen ist in WO 02/077060 und der darin zitierten Literatur ausführlich beschrieben. Die im Folgenden verwendeten Comonomere **M1** bis **M7** seien hier der Übersichtlichkeit halber nochmals abgebildet:

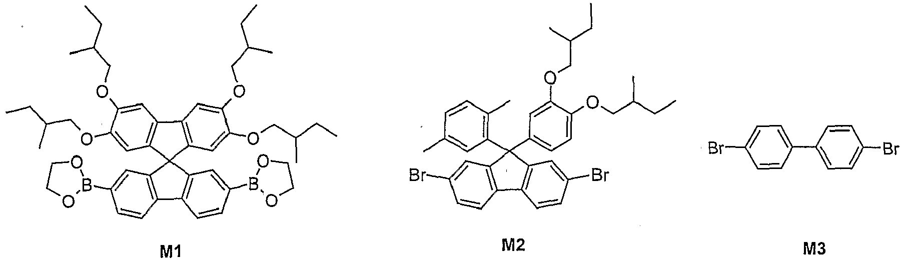

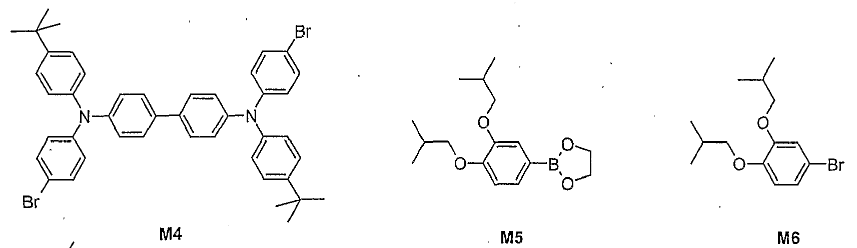

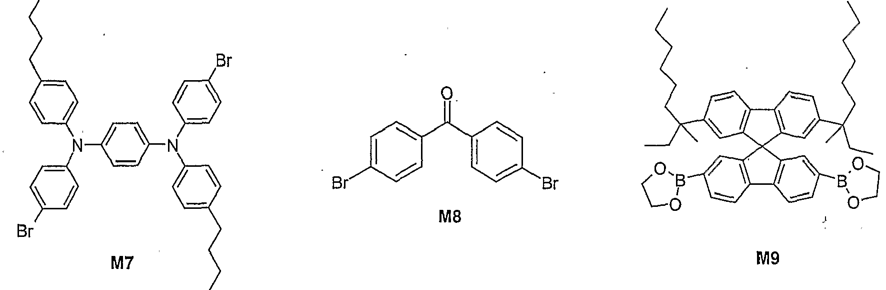

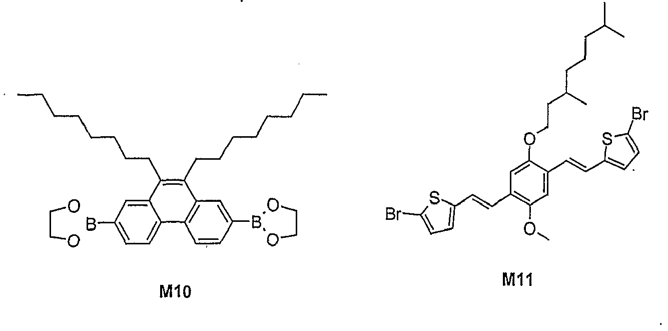

### Beispiel 3: Synthese der erfindungsgemäßen phosphoreszierenden Copolymere

Die Polymere wurden durch SUZUKI-Kupplung synthetisiert, wie allgemein beschrieben in WO 03/048225. Die Zusammensetzung der synthetisierten Polymere **P1** bis **P5** (Beispiele 5 bis 9) und der Vergleichspolymere bzw. Vergleichsblends **V1** bis **V3** (Beispiele 10 bis 13) ist in Tabelle 1 zusammen mit ihren physikalischen Eingeschaften aufgeführt.

### Beispiel 4: Herstellung der polymeren Leuchtdioden (PLEDs)

Wie PLEDs dargestellt werden können, ist in WO 04/037887 und der darin zitierten Literatur ausführlich beschrieben.

### Beispiele 5 bis 17: Device-Beispiele

Alle hergestellten Polymere wurden auch in PLEDs untersucht. Die Zusammensetzung der Polymere ebenso wie die Ergebnisse in der Elektrolumineszenz sind in Tabelle 1 zusammengefasst.
Als Vergleichsbeispiele dienen lineare (unverzweigte) Polymere, die durch Verwendung eines Dibromderivats des Iridiumkomplexes (**Ir2** und **Ir3**) erhalten wurden. Weiterhin als Vergleichsbeispiele dienen Blends eines Polymers, das keinen Metallkomplex enthält, mit einer löslichen Variante des Iridiumkomplexes (**Ir4**) und mit dem tribromierten Iridium-Monomer (**Ir1**).

**Tabelle 1: Device-Ergebnisse mit erfindungsgemäßen Copolymeren und Vergleichspolymeren und -Blends**

| **Beispiel** | **Polymer** | **Ir-Komplex ^{a}** | **sonst. Monomer ^{a}** | **Polydispersität** | **Max. Eff. / cd/A** | **U @100 cd/m² / V** | **CIE x / y ^{b}** | **Lebensdauer ^{c} / h** |
|---|---|---|---|---|---|---|---|---|
| Beispiel 5 | **P1** | 1 % **Ir1** | 50% **M1,** 39% **M2,** 10% **M4,** 1.4% **M5**, 0.4% **M6** | 4.1 | 6.1 | 4.14 | 0.68 / 0.32 | 108 |
| Beispiel 6 | **P2** | 1.5% **Ir1** | 50% **M1,** 38.5% **M2,** 10% **M4,** 1.9% **M5**, 0.4% M6 | 5.3 | 4.9 | 4.70 | 0.68 / 0.32 | 169 |
| Beispiel 7 | **P3** | 1 % **Ir1** | 50% **M1,** 39% **M3,** 10% **M4,** 1.5% **M5**, 0.5% M6 | 5.1 | 5.0 | 4.65 | 0.68 / 0.32 | 214 |
| Beispiel 8 | **P4** | 1 % **Ir1** | 50% **M1,** 41% **M2**, 8% **M4,** 1.5% **M5**, 0.5% **M6** | 7.5 | 6.7 | 4.65 | 0.67 / 0.32 | n. a. |
| Beispiel 9 | **P5** | 1 % **Ir1** | 50% **M1,** 39% **M2,** 10% **M7,** 1.5% **M5**, 0.5% **M6** | 6.2 | 7.4 | 5.41 | 0.68 / 0.32 | 66^{d} |
| Beispiel 10 | **P6** | 1 % **Ir1** | 50% **M1,** 29% **M2,** 10% **M4,** 10% **M8**, 1.5% **M5**, 0.5% **M6** | 6.2 | 8.5 | 3.85 | 0.67 / 0.32 | 250^{d} |
| Beispiel 11 | **P7** | 1 % **Ir1** | 50% **M9, 26% M2**, 8% **M4,** 15% **M8**, 1.5% **M5**, 0.5% **M6** | 6.6 | 7.1 | 3.68 | 0.67 / 0.32 | 530^{d} |
| Beispiel 12 | **P8** | 1 % **Ir1** | 50% **M10,** 35% **M2**, 6% **M4,** 8% **M8**, 1.5% **M5,** 0.5% **M6** | 5.1 | 6.3 | 5.3 | 0.67 / 0.32 | 1300° |
| Beispiel 13 | **P9** | 0.02 % **Ir1** | 50% **M1,** 40% **M2,** 10% **M4,** 0.1% **M11,** 0.5% **M5,** 0.5% **M6** | 2.9 | 7.4 | 3.9 | 0.35 / 0.39 | 130^{d} |
| Beispiel 14 (Vergleich) | **V1** | 1 % **Ir2** | 50% **M1,** 39% **M2,** 10% **M7** | 3.3 | 1.9 | 6.9 | 0.66/0.31 | 119^{C} |
| Beispiel 15 (Vergleich) | **V2** | 1 % **Ir3** | 50% **M1,** 39% **M2,** 10% **M7** | 3.2 | 4.3 | 5.2 | 0.68 / 0.32 | 50 |
| Beispiel 16 (Vergleich) | **V3** | 8 Gew.% **Ir4** (eingemischt) | 50% **M1**, 40% **M2,** 10% **M7** | 2.8 | 4.5 | 4.8 | 0.68 / 0.32 | n. a. |
| Beispiel 17 (Vergleich) | **V3** | 1 mol% **Ir1** (eingemischt) | 50% **M1,** 40% **M2,** 10% **M7** | 2.8 | 3.0 | 6.5 | 0.67 / 0.33 | 1 |

| | | | | | | | | |
|---|---|---|---|---|---|---|---|---|
| ^{a} Die Anteile der Monomere bezeichnen mol%, bezogen auf alle vorhandenen Wiederholeinheiten im Polymer. ^{b} CIE-Koordinaten: Chromatizitäts-Koordinaten der Commission Internationale de l'Eclairage von 1931 ^{c} Als Lebensdauer ist hier die Zeit definiert, in der die Leuchtdichte der Leuchtdiode auf die Hälfte der Anfangsleuchtdichte abgefallen ist bei einer Stromdichte von 10 mA/cm² ^{d} Hier wurde die Lebensdauer nicht bei einer Stromdichte von 10 mA/cm², sondern bei einer Anfangshelligkeit von 800 cd/m² gemessen. | | | | | | | | |

Wie man leicht der Tabelle 1 entnehmen kann, weisen die erfindungsgemäßen Polymere deutlich höhere Effizienzen und niedrigere Spannungen bei gleichzeitig längerer Lebensdauer auf als Vergleichspolymere und Vergleichs-Blends. So fällt beispielsweise auf, dass insbesondere das Vergleichspolymer **V1** aus Beispiel 10 eine deutlich niedrigere Effizienz bei deutlich höherer Betriebsspannung im Vergleich zum erfindungsgemäßen Polymer **P1,** das bis auf die Verzweigung vergleichbar aufgebaut ist, aufweist. Der Effekt tritt auch beim Vergleichspolymer **V2** auf; hier ist auch die Lebensdauer um einen Faktor von mehr als zwei geringer. In einem vergleichbaren Blend (Beispiel 12, Iridium-Komplex **Ir4** in Polymer **V3**) fällt auf, dass ein deutlich höherer Anteil der Iridium-Verbindung für akzeptable Effizienzen benötigt wird, wobei die Effizienzen immer noch niedriger sind als im erfindungsgemäßen Polymer. Das Vergleichsbeispiel 13 (**Ir1** eingemischt in das Vergleichspolymer **V3**) zeigt, dass das Monomer **Ir1** in den erfindungsgemäßen Polymeren tatsächlich kovalent an das Polymer gebunden ist, da in diesem Vergleichs-Blend die Effizienz deutlich niedriger, die Spannung deutlich höher und die Lebensdauer um einen Faktor von mehr als 100 niedriger ist.

## Patentansprüche

1. Phosphoreszierende Copolymere, enthaltend 0.05 bis 10 mol% mindestens eines Triplett-Emitters, **dadurch gekennzeichnet, dass** der Triplett-Emitter mindestens drei Verknüpfungen zu dem Polymer aufweist, mit der Maßgabe, dass das Polymer kein 9,9-Dioctylfluoren enthält, wenn der Triplett-Emitter ein unsubstituiertes Tris(phenylpyridin)iridium(III) ist.

2. Phosphoreszierende Copolymere gemäß Anspruch 1, **dadurch gekennzeichnet, dass** sie konjugiert oder teilkonjugiert sind.

3. Phosphoreszierende Copolymere gemäß Anspruch 1 und/oder 2, **dadurch gekennzeichnet, dass** sie weitere Strukturelemente enthalten.

4. Phosphoreszierende Copolymere gemäß Anspruch 3, **dadurch gekennzeichnet, dass** die weiteren Strukturelemente das Polymergrundgerüst bilden und ausgewählt sind aus Fluorenderivaten, Spirobifluorenderivaten, 9,10-Dihydrophenanthrenderivaten, 4,5-Dihydropyrenderivaten, 4,5,9,10-Tetrahydropyrenderivaten, Phenanthrenderivaten und cis- und trans-Indenofluorenderivaten.

5. Phosphoreszierende Copolymere gemäß Anspruch 4, **dadurch gekennzeichnet, dass** eines der Strukturelemente ein Spirobifluorenderivat oder ein Phenanthrenderivat ist.

6. Phosphoreszierende Copolymere gemäß einem oder mehreren der Ansprüche 3 bis 5, **dadurch gekennzeichnet, dass** die Strukturelemente Lochtransporteigenschaften aufweisen und ausgewählt sind aus der Gruppe der Triarylaminderivate, Benzidinderivate, Tetraarylen-para-phenylendiaminderivate, Triarylphosphinderivate, Phenothiazinderivate, Phenoxazinderivate, Dihydrophenazinderivate, Thianthrenderivate, Dibenzo-*p*-dioxinderivate, Phenoxathiinderivate, Carbazolderivate, Azulenderivate, Thiophenderivate, Pyrrolderivate, Furanderivate und weiterer O-, S- oder N-haltiger Heterocyclen mit hoch liegendem HOMO.

7. Phosphoreszierende Copolymere gemäß einem oder mehreren der Ansprüche 3 bis 6, **dadurch gekennzeichnet, dass** die Strukturelemente Elektronentransporteigenschaften aufweisen und ausgewählt sind aus der Gruppe der Pyridinderivate, Pyrimidinderivate, Pyridazinderivate, Pyrazinderivate, Anthracenderivate, Pyrenderivate, Triarylborane, Oxadiazolderivate, Chinolinderivate, Chinoxalinderivate, Phenazinderivate und weiterer O-, S- oder N-haltiger Heterocyclen mit niedrig liegendem LUMO.

8. Phosphoreszierende Copolymere gemäß einem oder mehreren der Ansprüche 3 bis 7, **dadurch gekennzeichnet, dass** die Strukturelemente den Übergang vom Singulett- zum Triplett-Zustand verbessern und ausgewählt sind aus der Gruppe der Carbazole, der Ketone, der Phosphinoxide, der Sulfoxide oder der Arylsilane.

9. Phosphoreszierende Copolymere gemäß Anspruch 8, **dadurch gekennzeichnet, dass** die Strukturelemente ausgewählt sind aus aromatischen Ketonen oder aromatischen Phosphinoxiden.

10. Phosphoreszierende Copolymere gemäß einem oder mehreren der Ansprüche 1 bis 9, **dadurch gekennzeichnet, dass** sie durch Einbau des entsprechend trifunktionalisierten Triplett-Emitters als Monomer erhältlich sind.

11. Phosphoreszierende Copolymere gemäß einem oder mehreren der Ansprüche 1 bis 10, **dadurch gekennzeichnet, dass** es sich um metallorganische Triplett-Emitter handelt.

12. Phosphoreszierende Copolymere gemäß einem oder mehreren der Ansprüche 1 bis 11, **dadurch gekennzeichnet, dass** die Triplett-Emitter ausschließlich chelatisierende Liganden enthalten.

13. Phosphoreszierende Copolymere gemäß einem oder mehreren der Ansprüche 1 bis 12, **dadurch gekennzeichnet, dass** der Triplett-Emitter eine Struktur gemäß Formel (1) aufweist, 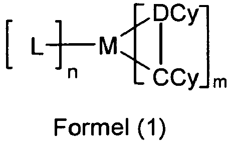 wobei für die verwendeten Symbole und Indizes gilt:
M ist bei jedem Auftreten gleich oder verschieden ein Hauptgruppenmetall, Übergangsmetall oder Lanthanoid mit der Ordnungszahl > 38;
DCy ist bei jedem Auftreten gleich oder verschieden eine cyclische Gruppe, die mindestens ein Donoratom, bevorzugt Stickstoff oder Phosphor, enthält, über welches die cyclische Gruppe an das Metall gebunden ist, und die einen oder mehrere Substituenten R¹ tragen kann; die Gruppen DCy und CCy sind über eine kovalente Bindung miteinander verbunden und können über die Reste R¹ bzw. R² noch weitere Verknüpfungen miteinander aufweisen;
CCy ist bei jedem Auftreten gleich oder verschieden eine cyclische Gruppe, die ein Kohlenstoffatom enthält, über welches die cyclische Gruppe an das Metall gebunden ist, und die einen oder mehrere Substituenten R¹ tragen kann;
L ist bei jedem Auftreten gleich oder verschieden ein zweizähnig chelatisierender Ligand, bevorzugt ein monoanionischer, zweizähnig chelatisierender Ligand;
R¹ ist bei jedem Auftreten gleich oder verschieden H, F, Cl, Br, I, NO₂, CN, eine geradkettige, verzweigte oder cyclische Alkyl- oder Alkoxygruppe mit 1 bis 40 C-Atomen, wobei eine oder mehrere nicht benachbarte CH₂-Gruppen durch C=O, C=S, C=Se, C=NR², -R²C=CR²-, -C≡C-, -O-, -S-, -NR²-, Si(R²)₂ oder -CONR²- ersetzt sein können und wobei ein oder mehrere H-Atome durch F, Cl, Br, I, CN, NO₂ ersetzt sein können, oder ein aromatisches oder heteroaromatisches Ringsystem mit 5 bis 40 aromatischen Ringatomen, das durch einen oder mehrere nicht-aromatische Reste R¹ substituiert sein kann; dabei können mehrere Substituenten R¹, sowohl am selben Ring als auch an den beiden unterschiedlichen Ringen zusammen wiederum ein weiteres mono- oder polycyclisches, aliphatisches oder aromatisches Ringsystem aufspannen;
R² ist gleich oder verschieden bei jedem Auftreten H oder ein aliphatischer oder aromatischer Kohlenwasserstoffrest mit 1 bis 20 C-Atomen;
m ist bei jedem Auftreten 1, 2 oder 3;
n ist bei jedem Auftreten 0, 1 oder 2;
dabei bestehen mindestens drei Verknüpfungen der Einheit gemäß Formel (1) mit dem Polymer.

14. Phosphoreszierende Copolymere gemäß Anspruch 13, **dadurch gekennzeichnet, dass** der Index m = 2 oder 3 und der Index n = 0 ist.

15. Phosphoreszierende Copolymere gemäß einem oder mehreren der Ansprüche 1 bis 14, **dadurch gekennzeichnet, dass** die Einheiten gemäß Formel (1) symmetrisch aufgebaut sind.

16. Phosphoreszierende Copolymere gemäß einem oder mehreren der Ansprüche 1 bis 14, **dadurch gekennzeichnet, dass** die Einheiten gemäß Formel (1) unsymmetrisch aufgebaut sind.

17. Phosphoreszierende Copolymere gemäß einem oder mehreren der Ansprüche 1 bis 16, **dadurch gekennzeichnet, dass** das Metall M des Triplett-Emitters ausgewählt ist aus der Gruppe der Übergangsmetalle mit einer Ordnungszahl > 38.

18. Phosphoreszierende Copolymere gemäß Anspruch 17, **dadurch gekennzeichnet, dass** das Metall M des Triplett-Emitters ausgewählt ist aus den Elementen Wolfram, Rhenium, Ruthenium, Osmium, Rhodium, Iridium, Palladium, Platin und Gold.

19. Phosphoreszierende Copolymere gemäß einem oder mehreren Ansprüche 1 bis 18, **dadurch gekennzeichnet, dass** die Anknüpfung an das Polymer über mindestens drei Liganden erfolgt.

20. Blends aus einem oder mehreren Copolymeren gemäß einem oder mehreren der Ansprüche 1 bis 19 mit einem oder mehreren konjugierten, teilkonjugierten oder nicht-konjugierten Polymeren, Oligomeren, Dendrimeren oder niedermolekularen Verbindungen.

21. Lösungen und Formulierungen aus einem oder mehreren der Copolymere oder Blends gemäß einem oder mehreren der Ansprüche 1 bis 20 in einem oder mehreren Lösungsmitteln.

22. Verwendung eines Copolymers oder Blends oder einer Lösung gemäß einem oder mehreren der Ansprüche 1 bis 21 in einer organischen elektronischen Vorrichtung.

23. Organische elektronische Vorrichtung mit einer oder mehreren Schichten, wobei mindestens eine dieser Schichten mindestens ein Copolymer oder Blend gemäß einem oder mehreren der Ansprüche 1 bis 20 enthält.

24. Organische elektronische Vorrichtung gemäß Anspruch 23, **dadurch gekennzeichnet, dass** es sich um organische bzw. polymere Leuchtdioden, organische Solarzellen, nicht-lineare Optik, organische optische Detektoren, organische Feld-Quench-Devices oder organische Laserdioden handelt.

## Claims

1. Phosphorescent copolymers containing 0.05 to 10 mol% of at least one triplet emitter, **characterised in that** the triplet emitter has at least three links to the polymer, with the proviso that the polymer contains no 9,9-dioctylfluorene if the triplet emitter is an unsubstituted tris(phenylpyridine)iridium(III).

2. Phosphorescent copolymers according to Claim 1, **characterised in that** they are conjugated or partially conjugated.

3. Phosphorescent copolymers according to Claim 1 and/or 2, **characterised in that** they contain further structural elements.

4. Phosphorescent copolymers according to Claim 3, **characterised in that** the further structural elements form the polymer backbone and are selected from fluorene derivatives, spirobifluorene derivatives, 9,10-dihydrophenanthrene derivatives, 4,5-dihydropyrene derivatives, 4,5,9,10-tetrahydropyrene derivatives, phenanthrene derivatives and cis- and trans-indenofluorene derivatives.

5. Phosphorescent copolymers according to Claim 4, **characterised in that** one of the structural elements is a spirobifluorene derivative or a phenanthrene derivative.

6. Phosphorescent copolymers according to one or more of Claims 3 to 5, **characterised in that** the structural elements have hole-transport properties and are selected from the group of the triarylamine derivatives, benzidine derivatives, tetraarylene-para-phenylenediamine derivatives, triarylphosphine derivatives, phenothiazine derivatives, phenoxazine derivatives, dihydrophenazine derivatives, thianthrene derivatives, dibenzo-p-dioxin derivatives, phenoxathiyne derivatives, carbazole derivatives, azulene derivatives, thiophene derivatives, pyrrole derivatives, furan derivatives and further O-, S- or N-containing heterocycles having a high HOMO.

7. Phosphorescent copolymers according to one or more of Claims 3 to 6, **characterised in that** the structural elements have electron-transport properties and are selected from the group of the pyridine derivatives, pyrimidine derivatives, pyridazine derivatives, pyrazine derivatives, anthracene derivatives, pyrene derivatives, triarylboranes, oxadiazole derivatives, quinoline derivatives, quinoxaline derivatives, phenazine derivatives and further O-, S- or N-containing hetero-cycles having a low LUMO.

8. Phosphorescent copolymers according to one or more of Claims 3 to 7, **characterised in that** the structural elements improve the transition from the singlet state to the triplet state and are selected from the group of the carbazoles, the ketones, the phosphine oxides, the sulfoxides or the arylsilanes.

9. Phosphorescent copolymers according to Claim 8, **characterised in that** the structural elements are selected from aromatic ketones or aromatic phosphine oxides.

10. Phosphorescent copolymers according to one or more of Claims 1 to 9, **characterised in that** they are obtainable by incorporation of the correspondingly trifunctionalised triplet emitter as monomer.

11. Phosphorescent copolymers according to one or more of Claims 1 to 10, **characterised in that** the triplet emitters are organometallic.

12. Phosphorescent copolymers according to one or more of Claims 1 to 11, **characterised in that** the triplet emitters contain exclusively chelating ligands.

13. Phosphorescent copolymers according to one or more of Claims 1 to 12, **characterised in that** the triplet emitter has a structure of the formula (1) 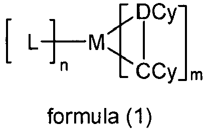 where the following applies to the symbols and indices used:
M is on each occurrence, identically or differently, a main-group metal, transition metal or lanthanoid having an atomic number > 38;
DCy is on each occurrence, identically or differently, a cyclic group which contains at least one donor atom, preferably nitrogen or phosphorus, via which the cyclic group is bonded to the metal and which may carry one or more substituents R¹; the groups DCy and CCy are bonded to one another via a covalent bond and may have further links to one another via the radicals R¹ or R²;
CCy is on each occurrence, identically or differently, a cyclic group which contains a carbon atom via which the cyclic group is bonded to the metal and which may carry one or more substituents R¹;
L is on each occurrence, identically or differently, a bidentate-chelating ligand, preferably a monoanionic, bidentate-chelating ligand;
R¹ is on each occurrence, identically or differently, H, F, Cl, Br, I, NO₂, CN, a straight-chain, branched or cyclic alkyl or alkoxy group having 1 to 40 C atoms, in which one or more non-adjacent CH₂ groups may be replaced by C=O, C=S, C=Se, C=NR², -R²C=CR²-, -C≡C-, -O-, -S-, -NR²-, Si(R²)₂ or -CONR²- and in which one or more H atoms may be replaced by F, Cl, Br, I, CN or NO₂, or an aromatic or heteroaromatic ring system having 5 to 40 aromatic ring atoms, which may be substituted by one or more non-aromatic radicals R¹; a plurality of substituents R¹ here, both on the same ring and also on the two different rings, may together in turn form a further mono- or polycyclic, aliphatic or aromatic ring system;
R² is, identically or differently on each occurrence, H or an aliphatic or aromatic hydrocarbon radical having 1 to 20 C atoms;
m is on each occurrence 1, 2 or 3;
n is on each occurrence 0, 1 or 2;
where the unit of the formula (1) has at least three links to the polymer.

14. Phosphorescent copolymers according to Claim 13, **characterised in that** the index m = 2 or 3 and the index n = 0.

15. Phosphorescent copolymers according to one or more of Claims 1 to 14, **characterised in that** the units of the formula (1) have a symmetrical structure.

16. Phosphorescent copolymers according to one or more of Claims 1 to 14, **characterised in that** the units of the formula (1) have an asymmetrical structure.

17. Phosphorescent copolymers according to one or more of Claims 1 to 16, **characterised in that** the metal M of the triplet emitter is selected from the group of the transition metals having an atomic number > 38.

18. Phosphorescent copolymers according to Claim 17, **characterised in that** the metal M of the triplet emitter is selected from the elements tungsten, rhenium, ruthenium, osmium, rhodium, iridium, palladium, platinum and gold.

19. Phosphorescent copolymers according to one or more of Claims 1 to 18, **characterised in that** the linking to the polymer takes place via at least three ligands.

20. Blends of one or more copolymers according to one or more of Claims 1 to 19 with one or more conjugated, partially conjugated or non-conjugated polymers, oligomers, dendrimers or low-molecular-weight compounds.

21. Solutions and formulations of one or more of the copolymers or blends according to one or more of Claims 1 to 20 in one or more solvents.

22. Use of a copolymer or blend or solution according to one or more of Claims 1 to 21 in an organic electronic device.

23. Organic electronic device having one or more layers, where at least one of these layers comprises at least one copolymer or blend according to one or more of Claims 1 to 20.

24. Organic electronic device according to Claim 23, **characterised in that** it is an organic or polymeric light-emitting diode, organic solar cell, nonlinear optic, organic optical detector, organic field-quench device or organic laser diode.

## Revendications

1. Copolymères phosphorescents contenant 0,05 à 10 % (pourcentage molaire) d'au moins un émetteur triplet, **caractérisés en ce que** l'émetteur triplet comporte au moins trois liens sur le polymère, étant en entendu que le polymère ne contient pas de 9,9-dioctylfluorène si l'émetteur triplet est un tris(phénylpyridine)-iridium(III) non substitué.

2. Copolymères phosphorescents selon la revendication 1, **caractérisés en ce qu'**ils sont conjugués ou partiellement conjugués.

3. Copolymères phosphorescents selon la revendication 1 et/ou 2, **caractérisés en ce qu'**ils contiennent d'autres éléments structurels.

4. Copolymères phosphorescents selon la revendication 3, **caractérisés en ce que** les autres éléments structurels forment le squelette de polymère et sont choisis parmi les dérivés de fluorène, les dérivés de spirobifluorène, les dérivés de 9,10-dihydrophénanthrène, les dérivés de 4,5-dihydropyrène, les dérivés de 4,5,9,10-tétrahydropyrène, les dérivés de phénanthrène et les dérivés de cis- et trans-indénofluorène.

5. Copolymères phosphorescents selon la revendication 4, **caractérisés en ce que** l'un des éléments structurels est un dérivé de spirobifluorène ou un dérivé de phénanthrène.

6. Copolymères phosphorescents selon une ou plusieurs des revendications 3 à 5, **caractérisés en ce que** les éléments structurels présentent des propriétés de transport de trous et sont choisis parmi le groupe constitué par les dérivés de triarylamine, les dérivés de benzidine, les dérivés de tétraarylène-para-phénylène-diamine, les dérivés de triarylphosphine, les dérivés de phénothiazine, les dérivés de phénoxazine, les dérivés de dihydrophénazine, les dérivés de thian-thrène, les dérivés de dibenzo-p-dioxine, les dérivés de phénoxathiyne, les dérivés de carbazole, les dérivés d'azulène, les dérivés de thiophène, les dérivés de pyrrole, les dérivées de furane et d'autres hétérocycles contenant O, S ou N présentant un niveau orbital occupé le plus haut (HOMO) élevé.

7. Copolymères phosphorescents selon une ou plusieurs des revendications 3 à 6, **caractérisés en ce que** les éléments structurels présentent des propriétés de transport d'électrons et sont choisis parmi le groupe constitué par les dérivés de pyridine, les dérivés de pyrimidine, les dérivés de pyridazine, les dérivés de pyrazine, les dérivés d'anthracène, les dérivés de pyrène, les dérivés de triarylboranes, les dérivés d'oxadiazole, les dérivés de quinoline, les dérivés de quinoxaline, les dérivés de phénazine et d'autres hétérocycles contenant O, S ou N présentant un niveau orbital non occupé le plus bas (LUMO) faible.

8. Copolymères phosphorescents selon une ou plusieurs des revendications 3 à 7, **caractérisés en ce que** les éléments structurels améliorent la transition de l'état singlet à l'état triplet et sont choisis parmi le groupe constitué par les carbazoles, les cétones, les oxydes de phosphine, les sulfoxydes ou les arylsilanes.

9. Copolymères phosphorescents selon la revendication 8, **caractérisés en ce que** les éléments structurels sont choisis parmi les cétones aromatiques ou les oxydes de phosphine aromatiques.

10. Copolymères phosphorescents selon une ou plusieurs des revendications 1 à 9, **caractérisés en ce qu'**ils peuvent être obtenus par incorporation de l'émetteur triplet trifonctionnalisé en correspondance en tant que monomère.

11. Copolymères phosphorescents selon une ou plusieurs des revendications 1 à 10, **caractérisés en ce que** les émetteurs triplet sont organométalliques.

12. Copolymères phosphorescents selon une ou plusieurs des revendications 1 à 11, **caractérisés en ce que** les émetteurs triplet contiennent exclusivement des ligands chélatants.

13. Copolymères phosphorescents selon une ou plusieurs des revendications 1 à 12, **caractérisés en ce que** l'émetteur triplet présente une structure de la formule (1) : 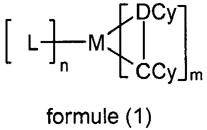 dans laquelle ce qui suit s'applique aux symboles et indices utilisés :
M est, pour chaque occurrence, de manière identique ou différente, un métal de groupe principal, un métal de transition ou un lanthanoïde présentant un numéro atomique > 38;
DCy est, pour chaque occurrence, de manière identique ou différente, un groupe cyclique qui contient au moins un atome donneur, de façon préférable azote ou phosphore, via lequel le groupe cyclique est lié au métal et qui peut être porteur d'un ou de plusieurs substituant(s) R¹; les groupes DCy et CCy sont liés l'un à l'autre via une liaison covalente et ils peuvent comporter d'autres liens l'un sur l'autre via les radicaux R¹ ou R² ;
CCy est, pour chaque occurrence, de manière identique ou différente, un groupe cyclique qui contient un atome de carbone via lequel le groupe cyclique est lié au métal et qui peut être porteur d'un ou de plusieurs substituant(s) R¹ ;
L est, pour chaque occurrence, de manière identique ou différente, un ligand chélatant bidenté, de façon préférable un ligand chélatant bidenté monoanionique ;
R¹ est, pour chaque occurrence, de manière identique ou différente, H, F, Cl, Br, I, NO₂, CN, un groupe alkyle ou alcoxy en chaîne droite, ramifié ou cyclique comportant 1 à 40 atome(s) de C, où un ou plusieurs groupe(s) CH₂ non adjacents peut/peuvent être remplacé(s) par C=O, C=S, C=Se, C=NR², -R²C=CR²-, -C≡C-, -O-, -S-, -NR²-, Si(R²)₂ ou -CONR²- et où un ou plusieurs atome(s) de H peut/peuvent être remplacé(s) par F, Cl, Br, I, CN ou NO₂, ou un système de cycle aromatique ou hétéroaromatique comportant 5 à 40 atomes de cycle aromatique, lequel peut être substitué par un radical ou plusieurs radicaux non aromatique(s) R¹ ; une pluralité de substituants R¹, à la fois sur le même cycle et également sur les deux cycles différents, peuvent ici en association à leur tour former un autre système de cycle aliphatique ou aromatique, monocyclique ou polycyclique ;
R² est, de manière identique ou différente pour chaque occurrence, H ou un radical hydrocarbone aliphatique ou aromatique comportant 1 à 20 atome(s) de C ;
m est, pour chaque occurrence, 1, 2 ou 3 ;
n est, pour chaque occurrence, 0, 1 ou 2 ;
où l'unité de la formule (1) comporte au moins trois liens sur le polymère.

14. Copolymères phosphorescents selon la revendication 13, **caractérisés en ce que** l'indice m = 2 ou 3 et l'indice n = 0.

15. Copolymères phosphorescents selon une ou plusieurs des revendications 1 à 14, **caractérisés en ce que** les unités de la formule (1) présentent une structure symétrique.

16. Copolymères phosphorescents selon une ou plusieurs des revendications 1 à 14, **caractérisés en ce que** les unités de la formule (1) présentent une structure asymétrique.

17. Copolymères phosphorescents selon une ou plusieurs des revendications 1 à 16, **caractérises en ce que** le métal M de l'émetteur triplet est choisi parmi le groupe des métaux de transition présentant un numéro atomique > 38.

18. Copolymères phosphorescents selon la revendication 17, **caractérisé en ce que** le métal M de l'émetteur triplet est choisi parmi les éléments tungstène, rhénium, ruthénium, osmium, rhodium, iridium, palladium, platine et or.

19. Copolymères phosphorescents selon une ou plusieurs des revendications 1 à 18, **caractérisés en ce que** le lien sur le polymère est réalisé via au moins trois ligands.

20. Mélanges d'un ou de plusieurs copolymères selon une ou plusieurs des revendications 1 à 19 avec un ou plusieurs polymère(s), oligomère(s), dendrimère(s) ou composé(s) de poids moléculaire faible conjugué(s), partiellement conjugué(s) ou non conjugué(s).

21. Solutions et formulations d'un ou de plusieurs des copolymères ou mélanges selon une ou plusieurs des revendications 1 à 20 dans un ou plusieurs solvant(s).

22. Utilisation d'un copolymère ou d'un mélange ou d'une solution selon une ou plusieurs des revendications 1 à 21 dans un dispositif électronique organique.

23. Dispositif électronique organique comportant une ou plusieurs couche(s), où au moins l'une de ces couches comprend au moins un copolymère ou mélange selon une ou plusieurs des revendications 1 à 20.

24. Dispositif électronique organique selon la revendication 23, **caractérisé en ce qu'**il s'agit d'une diode émettrice de lumière organique ou polymérique, d'une cellule solaire organique, d'une optique non linéaire, d'un détecteur optique organique, d'un dispositif à extinction de champ organique ou d'une diode laser organique.
